# EUROPÄISCHE PATENTSCHRIFT

(11) **EP 2 132 796 B1**
(45) Veröffentlichungstag und Bekanntmachung des Hinweises auf die Patenterteilung: **02.05.2012**
(21) Anmeldenummer: 08718222.6
(22) Anmeldetag: 26.03.2008
(51) Int. Cl.: H01L 41/083, H01L 41/053, H01L 41/04

(54) **PIEZOELEKTRISCHES BAUTEIL MIT SICHERHEITSSCHICHT UND VERFAHREN ZU DESSEN HERSTELLUNG**
PIEZOELECTRIC COMPONENT COMPRISING SECURITY LAYER AND METHOD FOR THE PRODUCTION THEREOF
COMPOSANT PIÉZOÉLECTRIQUE PRÉSENTANT UNE COUCHE DE SÉCURITÉ ET SON PROCÉDÉ DE RÉALISATION

(30) Priorität: 30.03.2007 DE 102007015457
(43) Veröffentlichungstag der Anmeldung: 16.12.2009
(73) Patentinhaber: Siemens Aktiengesellschaft, 80333 München (DE)
(72) Erfinder: KASTL, Harald, Johannes, 95686 Fichtelberg (DE); SCHUH, Carsten, 85598 Baldham (DE)
(86) Internationale Anmeldenummer: PCT/EP2008/053550
(87) Internationale Veröffentlichungsnummer: WO 2008/119704

(56) Entgegenhaltungen:
- WO-A-2006/001334
- DE-A1-102004 050 803
- US-A1- 2003 107 301

## Beschreibung

Die Erfindung betrifft ein piezoelektrisches Bauteil mit einem monolithischen Stapel, aufweisend abwechselnd übereinander angeordnete Piezokeramikschichten und Elektrodenschichten, mindestens eine im Stapel angeordnete poröse Sicherheitsschicht zur Bildung eines Risses bei mechanischer Überlastung des Stapels, mindestens eine an einem seitlichen Oberflächenabschnitt angeordnete Außenelektrode zur elektrischen Kontaktierung der Elektrodenschichten und eine Kunststoffummantelung des Stapels zum Schutz des Stapels, wobei die Kunststoffummantelung Silikon aufweist. Neben dem Bauteil wird ein Verfahren zum Herstellen des Bauteils angegeben.

Das piezoelektrische Bauteil ist ein keramischer Piezoaktor in monolithischer Vielschichtbauweise. Derartige Vielschichtaktoren weisen in einigen Ausführungsformen poröse, keramische oder metallische Sicherheitsschichten (Sicherheitsstrukturen) auf. Die porösen Sicherheitsschichten fungieren als Sollbruchstellen: Bei mechanischer Überlastung des Stapels des Piezoaktors kommt es vornehmlich in diesen Sicherheitsschichten zur Bildung von Rissen (Polungsrisse). Dadurch ist eine Lagedefinition und Führung der bei einer Polung oder im Betrieb entstehenden Polungsrisse möglich. Diese Sicherheitsschichten können von Keramikschichten oder von Elektrodenschichten (Innenelektroden) erhöhter Porosität gebildet werden.

Zur elektrischen Kontaktierung sind die Innenelektroden abwechselnd an von einander elektrisch isolierte, seitliche O-berflächenabschnitte des Stapels geführt. An diesen Oberflächenabschnitten sind Metallisierungen (Außenmetallisierungen) angebracht. Über diese Metallisierungen, die als Bestandteil von Außenelektroden betrachtet werden können, sind die Innenelektroden alternierend elektrisch parallel geschaltet.

Der Stapel des Piezoaktors ist mit einer Kunststoffummantelung aus Silikon versehen. Diese Kunststoffummantelung dient einer Passivierung des Stapels. Dies bedeutet: Durch die Kunststoffummantelung sind die bis an die seitlichen Oberflächen des Stapels reichenden Innenelektroden elektrisch isoliert und vor mechanischer Zerstörung geschützt.

Beim Aufbringen des Silikons auf die Oberfläche des Stapels kann es zum Eindringen von Silikonbestandteilen in die poröse Sicherheitsschicht kommen. Infolge einer solchen Infiltration kann es insbesondere im Bereich der Außenmetallisierung und direkt darunter durch elektrische Entladungen oder mechanische Druckspannungen zur Zersetzung des Silikons und zur Ablagerung von Zersetzungsprodukten kommen. Dies kann eine mechanische Kerbwirkung im Riss entstehen lassen, die wiederum eine Schädigung der Sicherheitsschicht und deren Umgebung nach sich ziehen kann. Dies kann Längsrisse entlang einer Stapelrichtung des Stapels verursachen. Ein vorzeitiger Ausfall des Bauteils ist damit vorprogrammiert. Beispiele sind in W02006/1334, US2003/107301 und DE 102004050803.

Aufgabe der vorliegenden Erfindung ist es, ein Eindringen von Silikon in die poröse Sicherheitsschicht während einer Herstellung eines piezoelektrischen Bauteils mit einem monolithischen Stapel zu verhindern.

Zur Lösung der Aufgabe wird ein piezoelektrisches Bauteil mit einem monolithischen Stapel angegeben, aufweisend abwechselnd übereinander angeordnete Piezokeramikschichten und Elektrodenschichten, mindestens eine im Stapel angeordnete poröse Sicherheitsschicht zur Bildung eines Risses bei mechanischer Überlastung des Stapels, mindestens eine an einem seitlichen Oberflächenabschnitt angeordnete Außenelektrode zur elektrischen Kontaktierung der Elektrodenschichten und eine Kunststoffummantelung des Stapels zum Schutz des Stapels, wobei die Kunststoffummantelung Silikon aufweist. Das piezoelektrische Bauteil ist dadurch gekennzeichnet, dass zwischen der Außenelektrode und der Kunststoffummantelung eine Beschichtung der Außenelektrode mit silikonfreiem Polymer angeordnet ist, die als Infiltrationsbarriere für Silikonbestandteile fungiert.

Zur Lösung der Aufgabe wird auch ein Verfahren zum Herstellen des Bauteils mit folgenden Verfahrensschritten angegeben: a) Bereitstellen eines monolithischen Stapels mit abwechselnd übereinander angeordneten Elektrodenschichten und Piezokeramikschichten, mindestens einer im Stapel angeordneten porösen Sicherheitsschicht zur Bildung eines Risses bei mechanischer Überlastung des Stapels, und eine an einem seitlichen Oberflächenabschnitt des Stapels angebrachten Außenelektrode, b) Anordnen einer Beschichtung aus silikonfreiem Polymer auf der Außenelektrode und c) Anordnen der Kunststoffummantelung auf der Beschichtung.

Die grundlegende Idee der Erfindung besteht darin, die Außenelektrode mit einem Silikon-freien Polymer abzudecken. Durch die Abdeckung ist gleichzeitig der unter der Außenelektrode befindliche Bereich einer porösen Sicherheitsschicht abgedeckt. Die Abdeckung fungiert als Infiltrationsbarriere für Silikonbestandteile.

Silikon-frei bedeutet in diesem Zusammenhang, dass sehr geringe Anteile an Silikon von unter 1 Mol% und insbesondere von unter 0,1 Mol% vorhanden sind. Als Silikon-freies Polymer kommt eine Vielzahl von Kunststoffen in Frage. Vorzugsweise ist das silikonfreie Polymer zumindest ein aus der Gruppe Polyamid (PA), Polyester, Polyimid (PI), Polyetheretherketon (PEEK) und Polyurethan (PU) ausgewählter Kunststoff. Andere geeignete Materialien sind beispielsweise Polyester-Sulfon (PES), Polybutylenterephthalat (PBT), Polyethylenterephthalat (PET), Polycarbonat (PC) und Epoxidharz (EP).

Die Außenelektrode weist verschiedene Bestandteile auf. So ist beispielsweise an einem seitlichen Oberflächenabschnitt des Stapels eine Einbrennmetallisierung (Außenmetallisierung) aufgebracht. Auf diese Außenmetallisierung wird beispielsweise mit Hilfe einer Lotbahn eine Drahtharfe angelötet. Dazu wird ein Bügellöt-(Thermodenlöt-)Prozess eingesetzt. Nach dem Anbringen der Außenelektrode erfolgt eine Abdeckung der Au-βenelektrode zumindest in dem Bereich, in dem die Außenelektrode an den Stapel angebracht ist (Kontaktierungsbereich). Vorteilhafterweise kann ein während eines Thermoden-Lötprozesses zum Schutz einer Thermode eingesetzte Karton®-Band direkt als Abdeckung verwendet werden.

Nachdem die Abdeckung aus dem Silikon-freien Polymer aufgebracht ist, kann die Kunststoffummantelung aus Silikon aufgebracht werden. Dies erfolgt beispielsweise in einem Spritzgussverfahren.

Das beschriebene piezoelektrische Bauteil mit dem Stapel in monolithischer Vielschichtbauweise wird vorzugsweise zum Ansteuern eines Ventils und insbesondere zum Ansteuern eines Einspritzventils einer Brennkraftmaschine verwendet.

Zusammenfassend ergeben sich mit der Erfindung folgende wesentlichen Vorteile:
- Mit Hilfe der Abdeckung aus Silikon-freiem Kunststoff direkt auf der Außenmetallisierung verzögert sich während des Herstellungsverlaufs und im Betrieb des Piezoaktors ein Eindringen von flüssigem Material in den Bereich der Sicherheitsschicht und direkt unter der Außenmetallisierung.
- Ebenso wird nach der Polung des Stapels beziehungsweise dem Auftreten von Polungsrissen in einer Sicherheitsschicht des Stapels das Eindringen der Materialien vermieden.
- Beides führt dazu, dass ungewollte mechanische Spannungen und Querriss-Initiierungen im Bereich einer Sicherheitsschicht vermieden werden. Dies führt zum Funktionserhalt des piezoelektrischen Bauteils, insbesondere bei hohen elektrischen, mechanischen und thermischen Belastungen.

Anhand eines Ausführungsbeispiels und der dazugehörigen Figuren wird die Erfindung im Folgenden näher beschrieben. Die Figuren sind schematisch und stellen keine maßstabsgetreuen Abbildungen dar.
- Figur 1: zeigt einen monolithischen Stapel eines piezoelektrischen Bauteils von der Seite.
- Figur 2: zeigt einen Schnitt durch den Stapel auf der Höhe einer Sicherheitsschicht.

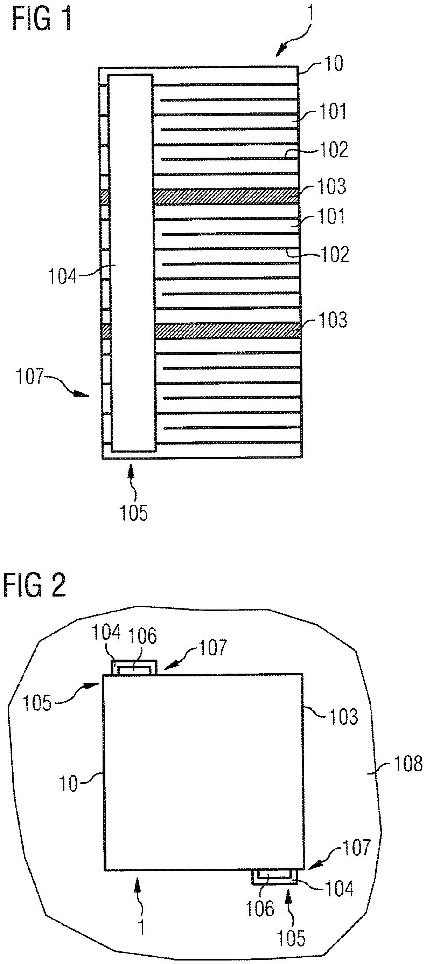

Das piezoelektrische Bauteil 1 ist ein monolithischer Piezoaktor in Vielschichtbauweise (Figuren 1 und 2). Der Piezoaktor in Vielschichtbauweise weist einen Stapel 10 aus abwechselnd übereinander angeordneten Piezokeramikschichten 101 und Elektrodenschichten 102 auf. Die Piezokeramikschichten weisen Bleizirkonattitanat auf. Die Elektrodenschichten werden von einer Palladium-Silber-Legierung gebildet. Im Stapel sind poröse Sicherheitsschichten 103 eingebaut. Durch die Sicherheitsschichten ist der Stapel in Teilstapel unterteilbar.

Gemäß einer ersten Ausführungsform ist die Sicherheitsschicht keramischer Natur. In einer dazu alternativen Ausführungsform wird die Sicherheitsschicht von einer Metallschicht gebildet. Bei beiden Ausführungsformen weist die Sicherheitsschicht eine im Vergleich zum Rest des Stapels erhöhte Porosität auf. Dies führt dazu, dass die Sicherheitsschicht als Sollbruchstelle fungiert: Bei mechanischer Überlastung des Stapels treten bevorzugt in dieser Sicherheitsschicht mit der erhöhten Porosität Risse auf. Damit ist die Steuerung der Rissbildung und der Ausbreitung des Risses möglich.

An seitlichen Oberflächenabschnitten 107 des Stapels sind Metallisierungen 106 zur elektrischen Kontaktierung der Elektrodenschichten des Stapels angeordnet. Über die beiden Metallisierungen können die Elektrodenschichten alternierend mit unterschiedlichen elektrischen Potenzialen beaufschlagt werden. Dazu sind nicht gezeigte Drahtharfen an die Metallisierungen mit Hilfe eines Bügellöt-Verfahrens gelötet.

Über den Metallisierungen befindet sich eine Abdeckung 104 aus einem Silikon-freien Polymer. Das Silikon-freie Polymer ist in einer ersten Ausführungsform ein Polyurethan. In einer alternativen Ausführungsform ist die Abdeckung aus Polyimid.

Den Abschluss bildet eine Ummantelung 108 aus einem Silikon. Zwischen der Außenelektrode und der Ummantelung ist die Abdeckung aus Silikon-freiem Polymer angeordnet.

Zum Herstellen des piezoelektrischen Bauteils wird zunächst ein monolithischer Stapel mit Piezokeramikschichten, Elektrodenschichten und poröser Sicherheitsschicht bereitgestellt. Dazu werden keramische Grünfolien mit Metall bedruckt, übereinander zu einem Grünfolienverbund gestapelt, entbindert und zum monolithischen Stapel gesintert. Die Grünfolien führen zu den Piezokeramikschichten. Aus dem aufgedruckten Metall (Metallschichten) resultieren die Elektrodenschichten. Im Grünfolienverbund wird zudem eine Ausgangsschicht der Sicherheitsschicht integriert, aus der während des Sintervorgangs die Sicherheitsschicht gebildet wird.

Anschließend werden an den seitlichen Oberflächenabschnitten des Stapels Außenelektroden angebracht. Dazu werden zunächst Metallisierungen aufgebracht. An die Metallisierung werden, wie bereits geschildert, Drahtharfen angelötet.

Nach dem Anlöten der Drahtharfen wird das Polymer bzw. vernetzbares, Silikon-freies Polymer aufgetragen. Dies erfolgt durch Spritzen. Nach dem Auftragen wird die Vernetzung des Polymers in geeigneter Weise initiiert. Es bildet sich die Abdeckung aus dem Silikon-freien Polymer.

Nach dem Herstellen der Abdeckung wird Silikon in einem Spritzgussverfahren aufgetragen und ausgehärtet. Das Silikon fungiert als Stütze für die Drähte der Drahtharfe. Darüber hinaus wird eine äußere Form (Kontur) des piezoelektrischen Bauteils gestaltet. Die äußere Form ist an einen Einsatz des Bauteils angepasst. Beispielsweise dient die Kunststoffummantelung einer Abrundung des Bauteils. In einer dazu alternativen Ausführungsform wird der monolithische Stapel inklusive Außenelektrode und Abdeckung aus Silikon-freiem Polymer in eine Hülse gesteckt und ein Zwischenraum zwischen der Hülse und dem Stapel mit Silikon ausgespritzt.

## Patentansprüche

1. Piezoelektrisches Bauteil (1) mit einem monolithischen Stapel (10), aufweisend
- abwechselnd übereinander angeordnete Piezokeramikschichten (101) und Elektrodenschichten (102),
- mindestens eine im Stapel (10) angeordnete poröse Sicherheitsschicht (103) zur Bildung eines Risses bei mechanischer Überlastung des Stapels (10),
- mindestens eine an einem seitlichen Oberflächenabschnitt (107) angeordnete Außenelektrode (106) zur elektrischen Kontaktierung der Elektrodenschichten (102) und
- eine Kunststoffummantelung (108) des Stapels (10) zum Schutz des Stapels-(10), wobei die Kunststoffummantelung (108) Silikon aufweist, wobei
- zwischen der Außenelektrode (106) und der Kunststoffummantelung (108) eine die Außenelektrode abdeckende, als Infiltrationsbarriere für Silikonbestandteile fungierende Beschichtung (104) der Außenelektrode (106) mit Silikon freiem Polymer angeordnet ist.

2. Bauteil nach Anspruch 1, wobei die Außenelektrode eine Metallisierungsbahn und/oder eine Lotbahn aufweist, die durch die Beschichtung abgedeckt ist.

3. Bauteil nach Anspruch 1 oder 2, wobei das Silikon-freie Polymer zumindest ein aus der Gruppe Polyamid, Polyester, Polyimid, Polyetheretherketon, Polyurethan und Epoxidharz ausgewählter Kunststoff ist.

4. Verfahren zum Herstellen eines Bauteils nach einem der Ansprüche 1 bis 3 mit folgenden Verfahrensschritten:
a) Bereitstellen eines monolithischen Stapels mit abwechselnd übereinander angeordneten Elektrodenschichten und Piezokeramikschichten, mindestens einer im Stapel angeordneten porösen Sicherheitsschicht zur Bildung eines Risses bei mechanischer Überlastung des Stapels, und einer an einem seitlichen Oberflächenabschnitt des Stapels angebrachten Außenelektrode,
b) Anordnen einer die Außenelektrode abdeckende Beschichtung aus Silikon freiem Polymer auf der Außenelektrode und
c) Anordnen der Kunststoffummantelung mit Silikon auf der Beschichtung.

5. Verfahren nach Anspruch 4, wobei zum Anordnen der Beschichtung nicht vernetztes oder teilvernetztes Ausgangsmaterial des Polymers durch ein aus der Gruppe Pinseln, Siebdruck und/oder Spritzen ausgewähltes Verfahren auf die Außenmetallisierung aufgetragen und anschließend vernetzt wird.

6. Verwendung eines piezoelektrischen Bauteils nach einem der Ansprüche 1 bis 3 zum Ansteuern eines Ventils und insbesondere eines Einspritzventils einer Brennkraftmaschine.

## Claims

1. Piezoelectric component (1) with a monolithic stack (10), featuring
- piezoceramic layers (101) and electrode layers (102) arranged alternately one on top of the other,
- at least one porous security layer (103) arranged in the stack (10) to form a crack if mechanical overload of the stack (10) occurs,
- at least one outer electrode (106) arranged on a lateral section of the surface (107) for electrical contacting of the electrode layers (102) and
- a plastic sheath (108) of the stack (10) for protection of the stack (10), with the plastic sheath (108) featuring silicon, with
- a coating (104) of the outer electrode (106) with silicon-free polymer covering the outer electrode, functioning as an infiltration barrier for silicon components, being arranged between the outer electrode (106) and the plastic sheath (108).

2. Component according to claim 1, with the outer electrode featuring a plating track and/or a solder track which is covered by the coating.

3. Component according to claim 1 or 2, with the silicon-free polymer being at least one plastic selected from the group polyamide, polyester, polyimide, polyetheretherketone polyurethane and epoxy resin.

4. Method for producing a component according to one of claims 1 to 3, with the following method steps:
a) Provision of a monolithic stack with electrode layers and piezoceramic layers arranged alternately one on top of the other, at least one porous security layer arranged in the stack for formation of a crack if a mechanical overload of the stack occurs, and an outer electrode arranged at a lateral section of the surface of the stack,
b) Arrangement on the outer electrode of a coating of silicon-free polymer covering the outer electrode and
c) Arrangement of the plastic sheath with silicon on the coating.

5. Method according to claim 4, whereby, for arranging the coating, non-wetted or part-wetted raw material of the polymer is applied to the outer plating using a method from the group painting, screen printing and/or injection and subsequently wetted.

6. Use of a piezoelectric component according to one of the claims 1 to 3 for controlling a valve and especially an injection valve of an internal combustion engine.

## Revendications

1. Composant piézoélectrique (1) présentant un empilement monolithique (10) comprenant
- une alternance de couches piézocéramiques (101) et de couches d'électrode (102) superposées,
- au moins une couche de sécurité poreuse (103) disposée dans l'empilement (10) et destinée à former une fissure en cas de surcharge mécanique de l'empilement (10),
- au moins une électrode extérieure (106) disposée sur une section de surface latérale (107) et destinée à assurer le contact électrique des couches d'électrode (102), et
- une gaine en matière plastique (108) de l'empilement (10) destinée à protéger l'empilement (10), la gaine en matière plastique (108) présentant du silicone,
- entre l'électrode extérieure (106) et la gaine en matière plastique (108) étant disposé un revêtement (104) de l'électrode extérieure (106), comprenant un polymère dépourvu de silicone, recouvrant l'électrode extérieure et servant de barrière d'infiltration pour des composantes de silicone.

2. Composant selon la revendication 1, l'électrode extérieure présentant une piste métallisée et/ou une piste soudée recouverte par le revêtement.

3. Composant selon la revendication 1 ou 2, le polymère dépourvu de silicone étant au moins une matière plastique choisie dans le groupe de polyamide, polyester, polyimide, polyétheréthercétone, polyuréthane et résine époxy.

4. Procédé de fabrication d'un composant selon l'une des revendications 1 à 3, comprenant les étapes de procédé suivantes :
a) mise à disposition d'un empilement monolithique comprenant une alternance de couches d'électrode et de couches piézocéramiques superposées, au moins une couche de sécurité poreuse disposée dans l'empilement et destinée à former une fissure en cas de surcharge mécanique de l'empilement, et une électrode extérieure disposée sur une section de surface latérale de l'empilement,
b) mise en place d'un revêtement sur l'électrode extérieure, fait d'un polymère dépourvu de silicone et recouvrant l'électrode extérieure, et
c) mise en place de la gaine en matière plastique comportant du silicone sur le revêtement.

5. Procédé selon la revendication 4 dans lequel, en vue de la mise en place du revêtement, une matière de base du polymère, non-réticulée ou partiellement réticulée, est appliquée sur la métallisation extérieure par un procédé choisi dans le groupe comprenant l'application au pinceau, la sérigraphie et/ou l'application au pistolet, laquelle matière est ensuite réticulée.

6. Utilisation d'un composant piézoélectrique selon l'une des revendications 1 à 3 pour commander une soupape et en particulier une soupape d'injection d'un moteur à combustion interne.
